# EUROPEAN PATENT APPLICATION

(11) **EP 2 946 854 A1**
(43) Date of publication of application: **25.11.2015**
(21) Application number: 14001811.0
(22) Date of filing: 23.05.2014
(51) Int. Cl.: B22F 1/00, B22F 1/02, H01L 31/00

(54) **Coated conductive metallic particles**

(71) Applicant: Heraeus Precious Metals North America Conshohocken LLC, West Conshohocken, PA 19428 (US)
(72) Inventor: Berube, Gregory, Nashua, New Hampshire 03062 (US)
(74) Representative: Brand, Normen

(57) **Abstract**

A conductive metallic particle coated with an organometallic compound, a metal salt, an inorganic oxide, an inorganic hydroxide, or a combination thereof, is provided. The invention also provides a process for preparing a coated conductive metallic particle comprising forming an organometallic coating, a metal salt coating, an inorganic oxide coating, an inorganic hydroxide coating, or a combination thereof, on a conductive metallic particle. Specifically, a process for preparing a coated conductive metallic particle, comprising (a) obtaining a mixture of at least one conductive metallic particle and at least one inorganic precursor in water, an organic solvent, or a combination thereof, (b) hydrolysing the inorganic precursor in the mixture, and (c) optionally adding at least one organic compound is provided. The invention also provides a coated a conductive metallic particle prepared by the claimed processes, as well as the use of the coated conductive metallic particle in a composition. A composition comprising the coated conductive metallic particles of the invention, such as an electroconductive composition comprising the coated conductive metallic particles, and an organic vehicle is also provided.

## Description

### Technical Field

The invention relates to coated conductive metallic particles and to the preparation of such coated particles. Specifically, the coated conductive metallic particles may be incorporated into a composition, such as an electroconductive composition, to improve sintering inhibition.

### Background

Solar cells are devices that convert the energy of light into electricity using the photovoltaic effect. Solar power is an attractive green energy source because it is sustainable and produces only non-polluting by-products. In operation, when light hits a solar cell, a fraction of the incident light is reflected by the surface and the remainder is transmitted into the solar cell. The photons of the transmitted light are absorbed by the solar cell, which is usually made of a semiconducting material such as silicon. The energy from the absorbed photons excites electrons of the semiconducting material from their atoms, generating electron-hole pairs. These electron-hole pairs are then separated by p-n junctions and collected by conductive electrodes which are applied on the solar cell surface. In this way, electricity may be conducted between interconnected solar cells.

Solar cells typically have electroconductive pastes applied to both their front and back surfaces. A typical electroconductive paste for forming front side electrodes contains metallic particles, glass frit, and an organic vehicle. These components are usually selected to take full advantage of the theoretical potential of the resulting solar cell. Glass compositions for use in electroconductive pastes which improve contact between the paste and the underlying substrate, while not adversely affecting the conductive properties of the paste, are desired.

There is, therefore, a need for new electroconductive compositions in which the amount of sintering inhibitor is reduced, but still remains effective in improving the properties of the paste.

### Summary

The invention provides a conductive metallic particle coated with an organometallic compound, a metal salt, an inorganic oxide, an inorganic hydroxide, or a combination thereof. In one embodiment, the coated particles are incorporated into an electroconductive composition. The coated conductive metallic particles improve the sintering inhibition of the electroconductive composition when fired, e.g., onto solar cells, thereby improving the series resistance, fill factor and efficiency of the cell.

The invention also provides a process for preparing an inorganic coated conductive metallic particle comprising forming an organometallic coating, a metal salt coating, an inorganic oxide coating, an inorganic hydroxide coating, or a combination thereof, on the conductive metallic particle.

The invention further provides a process for preparing an inorganic coated conductive metallic particle comprising (a) obtaining a mixture of at least one conductive metallic particle and at least one inorganic precursor in water, an organic solvent, or a combination thereof, (b) hydrolysing the inorganic precursor in the mixture, and (c) optionally adding at least one organic compound.

### Detailed Description

The coated conductive metallic particles of the invention may be useful as components in any number of applications, including, but not limited to, electroconductive compositions, resistor compositions, dielectric compositions, soldering compositions, decorative compositions, and sealing compositions. Such compositions may be used to form, for example, electric circuits, solar cells, LEDs, displays, capacitors, resistors, other known electronic components, and any combinations thereof.

### Coated Conductive Metallic Particles

The invention provides a conductive metallic particle coated with an organometallic compound, a metal salt, an inorganic oxide, an inorganic hydroxide, or a combination thereof.

Suitable conductive metallic particles for use in the invention include those which exhibit conductivity and which effectively sinter upon firing, such that they yield electrodes with high conductivity and low contact resistance. Conductive metallic particles known in the art suitable for use as solar cell surface electrodes that are also easy to solder, and mixtures or alloys thereof, can be used. Suitable examples of conductive metallic particles include, but are not limited to, elemental metals, alloys, metal derivatives, mixtures of at least two metals, mixtures of at least two alloys or mixtures of at least one metal with at least one alloy.

Metals which can be employed as the conductive metallic particles include, but are not limited to, silver, copper, aluminum, zinc, platinum, palladium, lead, nickel, tungsten, molybdenum, alloys thereof, particles where one metal is coated or mixed with at least another metal, and any combination thereof.

Alloys which can be employed as metallic particles according to the invention include alloys containing at least one metal (or at least two metals) selected from silver, copper, aluminum, zinc, platinum, palladium, lead, nickel, tungsten, molybdenum, or mixtures of two or more of those alloys.

In one embodiment, the conductive metallic particles are at least one of silver, aluminum, gold, and nickel, or any mixtures or alloys thereof. In a preferred embodiment, the conductive metallic particles are silver. The silver may be present as elemental silver, a silver alloy, or silver derivate. Suitable silver derivatives include, for example, silver alloys and/or silver salts, such as silver halides (e.g., silver chloride), silver oxide, silver nitrate, silver acetate, silver trifluoroacetate, silver orthophosphate, and combinations thereof.

The coated metallic particles described herein are coated with an organometallic compound, a metal salt, an inorganic oxide, an inorganic hydroxide, or a combination thereof. Any organometallic compound, metal salt, inorganic oxide, inorganic hydroxide, or combination thereof that is soluble in water and/or an organic solvent may be used to coat the metallic particles.

In one embodiment, the organometallic compound, metal salt, inorganic oxide, inorganic hydroxide, or combination thereof, is an organometallic compound, a metal salt, an inorganic oxide or an inorganic hydroxide of magnesium, calcium, strontium, barium, rhodium, tellurium, lead, zinc, vanadium, chromium, ytterbium, niobium, molybdenum, manganese, silver, tantalum, tungsten, lanthanum, aluminum, antimony, bismuth, boron, silicon, zirconium, phosphorous, selenium, yttrium, tin, and any combination thereof

In one embodiment, the organometallic compound, metal salt, inorganic oxide, inorganic hydroxide, or combination thereof, is rhodium (III) tris(ethylhexanoate), tellurium ethoxide, lead acetate, bismuth citrate, zinc acetate, zirconium tetra(n-propoxide), silver acetate, silver molybdate, silver tungstate, molybdenum oxide, tungsten oxide, or a combination thereof.

The coated conductive metallic particles can exhibit a variety of shapes, surfaces, sizes, surface area to volume ratios, oxygen content and oxide layers. A large number of shapes are known in the art. Some examples are spherical, angular, elongated (rod or needle like) and flat (sheet like). The coated conductive metallic particles may also be present as a combination of particles of different shapes. Conductive metallic particles with a shape, or combination of shapes, which favors sintering and adhesion are preferred according to the invention. One way to characterize such shapes without considering the surface nature of the particles is through the following parameters: length, width and thickness, as set forth herein.

In one embodiment, coated metallic particles with shapes as uniform as possible are preferred (i.e. shapes in which the ratios relating the length, the width and the thickness are as close as possible to 1. In additional embodiments, the ratios relating the length, the width and the thickness are at least about 0.7, preferably at least about 0.8, and more preferably at least about 0.6. At the same time, the ratios relating the length, the width and the thickness are not more than about 1.5, preferably not more than about 1.3, and more preferably not more than about 1.2. Examples of preferred shapes for the coated metallic particles in this embodiment are spheres and cubes, or combinations thereof, or combinations of one or more thereof with other shapes. In another embodiment according to the invention, coated metallic particles are preferred which have a shape of low uniformity, preferably with at least one of the ratios relating the dimensions of length, width and thickness being at least about 1.5, preferably at least about 3 and more preferably at least about 5. Preferred shapes according to this embodiment are flake shaped, rod or needle shaped, or a combination of flake shaped, rod or needle shaped with other shapes.

A variety of surface types of the coated conductive particles are known in the art. Surface types which favor effective sintering and yield advantageous electrical conductivity of the resulting electrode are preferred.

It one embodiment, the median particle diameter (d₅₀), as discussed herein, of the coated metallic particles is at least about 0.1 µm, preferably at least about 0.3 µm. At the same time, the median particle diameter (d₅₀) of the coated metallic particles is not more than about 50 µm, preferably not more than about 10 µm, more preferably not more than about 5 µm, and most preferably not more than about 3.5 µm.

In one embodiment, the coated metallic particles have a specific surface area, as set forth herein, of at least about 0.1 m²/g, preferably at least about 0.2 m²/g. At the same time, the coated metallic particles have a specific surface area, as set forth herein, of not more than about 100 m²/g, preferably not more than about 5 m²/g, and more preferably not more than about 3 m²/g.

### Preparation of the Coated Metallic Particles

In one embodiment, the invention provides a process for preparing a coated conductive metallic particle(e.g., an inorganic coated conductive metallic particle) comprising forming an organometallic coating, a metal salt coating, an inorganic oxide coating, an inorganic hydroxide coating, or a combination thereof, on the conductive metallic particle. In one embodiment, the coating is formed by hydrolyzing an inorganic precursor (e.g., by adjusting the pH). In another embodiment, the process further comprises adding at least one organic compound.

The invention further provides a process for preparing a coated conductive metallic particle (e.g., an inorganic coated conductive metallic particle) comprising (a) obtaining a mixture of at least one conductive metallic particle and at least one inorganic precursor in water, an organic solvent, or a combination thereof, (b) hydrolysing the inorganic precursor in the mixture (e.g., by adjusting the pH), and (c) optionally adding at least one organic compound.

In one embodiment, step (a) comprises mixing a slurry of at least one conductive metallic particle in water, a first organic solvent, or a combination thereof, with a solution of at least one inorganic precursor in water, a second organic solvent, or a combination thereof.

In one embodiment, the at least one organic compound is selected from the group consisting of amines, fatty acids, copolymers with acidic groups, acrylic acids, phosphoric acid esters, polymer salts having an acid group, carboxylic acid esters having a hydroxyl group, amides, carboxylic acids, phosphonic acids, organic acid anhydrides, acrylic copolymers, phosphates of a copolymer, alkyl ammonium salts of a block copolymer, modified acrylic block copolymers, modified acrylic block copolymers, their salts, and any combination of at least two thereof. In a preferred embodiment, the organic compound is oleic acid.

In another embodiment of any of the processes described herein, the hydrolysis is performed by adding and acid or a base. In one embodiment, the hydrolysis is performed by adding ammonium hydroxide, sodium hydroxide, potassium hydroxide, lithium hydroxide, sulfuric acid, hydrochloric acid, phosphoric acid, acetic acid, and any combination thereof.

In another embodiment of any of the processes described herein, the process further comprises drying the coated metallic particles. In one embodiment, the drying is performed at ambient pressure or at less than ambient pressure, at temperatures of about 20° C to about 800° C, over a time period of about 1 second to about 20 days. In a preferred embodiment, the drying is performed at temperatures of about 35° C to about 120° C.

In one embodiment, the coating on the conductive metallic particles is in the form of a hydroxide (e.g., rhodium hydroxide).

### Electroconductive Composition

In one embodiment, the coated metallic particles may be incorporated into an electroconductive composition used to form, e.g., electrodes on a solar cell. The electrodes provide the path by which conductivity occurs between solar cells.

A desired electroconductive composition is one which is highly conductive, so as to optimize the efficiency of the resulting solar cell. The components of the composition and proportions thereof may be selected such that the composition produces an electrode with optimal electrical properties and is easily printable. One way to achieve improved electrical properties is to improve the sintering inhibition of the conductive metal (such as silver) when printed and fired onto solar cells, thereby improving the series resistance of the cell and, therefore, the fill factor and efficiency of the cell.

In one embodiment, the electroconductive composition according to the invention comprises coated conductive metallic particles and an organic vehicle. In a preferred embodiment, the electroconductive composition according to the invention comprises coated conductive metallic particles, an organic vehicle, and a glass frit.

In one embodiment, the electroconductive composition comprises at least about 35 wt%, preferably at least about 50 wt%, more preferably at least about 70 wt%, and even more preferably at least about 85 wt% coated conductive metallic particles, and not more than about 99 wt% coated conductive metallic particles, preferably not more than about 94 wt%, based upon 100% total weight of the paste.

According to one embodiment, the electroconductive paste further includes inorganic and organic additives.

### Glass Frit

The glass frit of the invention acts as an adhesion media, facilitating the bonding between the metallic conductive particles and the silicon substrate, thus securing reliable electrical contact performance during the lifetime of the solar device. Specifically, the glass frit etches through the surface layers (e.g., antireflective layer) of the silicon substrate, such that effective contact can be made between the electroconductive paste and the silicon wafer.

Certain glass compositions result in high contact resistance at the silicon interface, due to the insulating effect of the glass between the electroconductive paste and silicon wafer. The glass frit of the invention has the advantage of providing lower contact resistance and higher overall cell efficiency. According to one embodiment, the glass frit is at least about 0.1 wt%, preferably at least about 0.2 wt%, more preferably at least about 0.3 wt%, and most preferably at least about 0.5 wt%. At the same time, the glass frit is not more than about 20 wt%, preferably not more than about 12 wt%, more preferably not more than about 8 wt %, and most preferably not more than about 5 wt%, based upon 100% total weight of the electroconductive paste.

Preferred glass frits are powders of amorphous or partially crystalline solids which exhibit a glass transition. The glass transition temperature T_{g} is the temperature at which an amorphous substance transforms from a rigid solid to a partially mobile undercooled melt upon heating. Methods for the determination of the glass transition temperature are well known to the person skilled in the art. Specifically, the glass transition temperature T_{g} is determined using a DSC apparatus SDT Q600 (commercially available from TA Instruments) which simultaneously records differential scanning calorimetry (DSC) and thermogravimetric analysis (TGA) curves. The instrument is equipped with a horizontal balance and furnace with a platinum/platinum-rhodium (type R) thermocouple. The sample holders used are aluminum oxide ceramic crucibles with a capacity of about 40-90 µl. For the measurements and data evaluation, the measurement software Q Advantage; Thermal Advantage Release 5.4.0 and Universal Analysis 2000, version 4.5A Build 4.5.0.5 is applied respectively. As pan for reference and sample, aluminum oxide pan having a volume of about 85 µl is used. An amount of about 10-50 mg of the sample is weighted into the sample pan with an accuracy of 0.01 mg. The empty reference pan and the sample pan are placed in the apparatus, the oven is closed and the measurement started. A heating rate of 10 K/min is employed from a starting temperature of 25 °C to an end temperature of 1000 °C. The balance in the instrument is always purged with nitrogen (N₂ 5.0) and the oven is purged with synthetic air (80% N₂ and 20% O₂ from Linde) with a flow rate of 50 ml/min. The first step in the DSC signal is evaluated as glass transition using the software described above, and the determined onset value is taken as the temperature for Tg.

Preferably, the glass transition temperature is below the desired firing temperature of the electroconductive paste. According to the invention, the glass frit has a glass transition temperature of at least about 200° C, preferably at least about 250° C. At the same time, the glass frit has a glass transition temperature of not more than about 700° C, preferably not more than about 650° C, and more preferably not more than about 500° C.

In the context of the invention, the glass frit preferably comprises elements, oxides, and/or compounds which generate oxides upon heating, other compounds, or mixtures thereof. In one embodiment, the glass frit comprises lead oxide (PbO) and silicon dioxide (SiO₂).

In one embodiment, the glass frit comprises at least about 50 wt%, preferably about 70 wt%, and more preferably about 75 wt% lead oxide. At the same time, the paste comprises not more than about 99 wt%, preferably not more than about 90 wt%, and more preferably not more than about 85 wt% lead oxide, based upon 100% total weight of the glass frit. In another embodiment, of any of the electroconductive paste compositions described herein, the glass frit comprises less than about 0.5% lead oxide. In one embodiment, of any of the electroconductive paste compositions described herein, the glass frit is free or substantially free (i.e., less than about 0.4 wt%, 0.3 wt%, 0.2 wt%, 0.1 wt% or 0.05 wt% based upon 100% total weight of the glass frit) of lead oxide.

In one embodiment, the glass frit comprises about at least about 0.1 wt%, preferably at least about 5 wt% silicon dioxide. At the same time, the paste comprises not more than about 15 wt%, and preferably not more than about 10 wt% silicon dioxide, based upon 100% total weight of the glass frit.

In one embodiment, the glass frit comprises at least about 50 wt%, preferably at least about 70 wt%, and more preferably at least about 75 wt% Bi₂O₃. At the same time, the paste comprises not more than about 99 wt%, preferably not more than about 90 wt%, and more preferably not more than about 85 wt% Bi₂O₃, based upon 100% total weight of the glass frit.

In another embodiment, the glass frit may comprise other lead-based compounds including, but not limited to, salts of lead halides, lead chalcogenides, lead carbonate, lead sulfate, lead phosphate, lead nitrate and organometallic lead compounds or compounds that can form lead oxides or salts during thermal decomposition. In an alternative embodiment, the glass frit may be lead-free. In addition to the components recited above, the glass frit may also comprise other compounds used to improve contact properties of the resulting electroconductive paste. For example, the glass frit may also comprise oxides or other compounds of Li, Na, K, Rb, Cs, Mg, Ca, Sr, Ba, V, Zr, Mo, Mn, Zn, B, P, Sn, Ga, Ge, In, Al, Sb, Bi, Ce, Cu, Ni, Cr, Fe, or Co, any combinations thereof. Examples of such oxides and compounds include, but are not limited to, germanium oxides, vanadium oxides, molybdenum oxides, niobium oxides, lithium oxides, tin oxides, indium oxides, rare earth oxides (such as La₂O₃ or cerium oxides), phosphorus oxides, transition metal oxides (such as copper oxides and chromium oxides), metal halides (such as lead fluorides and zinc fluorides), and combinations thereof. In a preferred embodiment, the glass frit comprises aluminum oxide (e.g., Al₂O₃), zinc oxide (ZnO), or both. Such oxides and compounds are preferably present in a total amount of at least about 0.1 and not more than about 15 wt% of the glass frit. In another embodiment, the glass frit comprises tellurium dioxide (TeO₂). In another embodiment, the glass frit comprises tellurium dioxide (TeO₂). In yet another embodiment, the glass frit does not contain an oxide of tellurium (e.g., TeO₂). In yet another embodiment, the glass frit comprises lead oxide. In yet another embodiment, the glass frit comprises vanadium oxide.

In another embodiment, the glass frit comprises vanadium. In yet another embodiment, the glass frit comprises lead. In yet another embodiment, the glass frit comprises phosphorous. In yet another embodiment, the glass frit comprises tellurium.

It is well known to the person skilled in the art that glass frit particles can exhibit a variety of shapes, surface natures, sizes, surface area to volume ratios and coating layers. A large number of shapes of glass frit particles are known in the art. Some examples are spherical, angular, elongated (rod or needle like) and flat (sheet like). Glass frit particles may also be present as a combination of particles of different shapes. Glass frit particles with a shape, or combination of shapes, which favor improved electrical contact of the produced electrode are preferred according to the invention. One way to characterize such shapes without considering the surface nature of the particles is through the following parameters: length, width and thickness. In the context of the invention, the length of a particle is given by the length of the longest spatial displacement vector, both endpoints of which are contained within the particle. The width of a particle is given by the length of the longest spatial displacement vector perpendicular to the length vector defined above both endpoints of which are contained within the particle. The thickness of a particle is given by the length of the longest spatial displacement vector perpendicular to both the length vector and the width vector, both defined above, both endpoints of which are contained within the particle.

In one embodiment according to the invention, glass frit particles with shapes as uniform as possible are preferred (i.e. shapes in which the ratios relating the length, the width and the thickness are as close as possible to 1. In one embodiment, the ratios relating the length, the width and the thickness are at least about 0.7, preferably at least about 0.8, and more preferably at least about 0.6. At the same time, the ratios relating the length, the width and the thickness are not more than about 1.5, preferably not more than about 1.3, and more preferably not more than about 1.2. Examples of preferred shapes for the glass frit particles in this embodiment are spheres and cubes, or combinations thereof, or combinations of one or more thereof with other shapes.

While glass frit particles may have an irregular shape, the particle size may be approximately represented as the diameter of the "equivalent sphere" which would give the same measurement result. Typically, glass frit particles in any given sample do not exist in a single size, but are distributed in a range of sizes, i.e., particle size distribution. One parameter characterizing particle size distribution is d₅₀. d₅₀ is the median diameter or the medium value of the particle size distribution. It is the value of the particle diameter at 50% in the cumulative distribution. Other parameters of particle size distribution include d₁₀, which represents the particle diameter at which 10% cumulative (from 0 to 100%) of the particles are smaller, and d₉₀, which represents the particle diameter at which 90% cumulative (from 0 to 100%) of the particles are smaller. Particle size distribution may be measured via laser diffraction, dynamic light scattering, imagine, electrophoretic light scattering, or any other methods known in the art. Specifically, particle size according to the invention is determined in accordance with ISO 13317-3:2001. A SediGraph III 5120 instrument, with software SediGraph 5120 (manufactured by Micromeritics Instrument Corp. of Norcross, Georgia), which operates according to X-ray gravitational technique, is used for the measurement. A sample of about 400 to 600 mg is weighed into a 50 ml glass beaker and 40 ml of Sedisperse P11 (from Micromeritics, with a density of about 0.74 to 0.76 g/cm³ and a viscosity of about 1.25 to 1.9 mPa·s) are added as suspending liquid. A magnetic stirring bar is added to the suspension. The sample is dispersed using an ultrasonic probe Sonifer 250 (from Branson) operated at power level 2 for 8 minutes while the suspension is stirred with the stirring bar at the same time. This pre-treated sample is placed in the instrument and the measurement started. The temperature of the suspension is recorded (typical range 24 °C to 45 °C) and for calculation data of measured viscosity for the dispersing solution at this temperature are used. Using density and weight of the sample (10.5 g/cm³ for silver) the particle size distribution is determined and given as d₁₀, d₅₀, and d₉₀.

It is preferred according to the invention that the median particle diameter d₅₀ of the glass frit particles is at least about 0.1 µm, preferably at least about 0.3 µm. At the same time, the median particle diameter d₅₀ of the coated metallic particles is not more than about 10 µm, preferably not more than about 5 µm, and more preferably not more than 3.5 µm. In one embodiment of the invention, the glass frit particles have a d₁₀ of at least about 0.1 µm, preferably at least about 0.15 µm, and more preferably at least about 0.2 µm. In one embodiment of the invention, the glass frit particles have a d₉₀ of not more than about 10 µm, preferably not more than about 5 µm, and more preferably not more than about 4.5 µm.

One way to characterize the shape and surface of a particle is by its surface area to volume ratio. The surface area to volume ratio, or specific surface area, may be measured by the BET (Brunauer-Emmett-Teller) method, which is known in the art. Specifically, BET measurements are made in accordance with DIN ISO 9277:1995. A Monosorb instrument (manufactured by Quantachrome Instruments), which operates according to the SMART method (Sorption Method with Adaptive dosing Rate), is used for the measurement. Samples are prepared for analysis in the built-in degas station. Flowing gas sweeps away impurities, resulting in a clean surface upon which adsorption may occur. The sample can be heated to a user-selectable temperature with the supplied heating mantle. Digital temperature control and display are mounted on the instrument front panel. After degassing is complete, the sample cell is transferred to the analysis station. Quick connect fittings automatically seal the sample cell during transfer. With the push of a single button, analysis commences. A dewar flask filled with coolant is automatically raised, immersing the sample cell and causing adsorption. The instrument detects when adsorption is complete (2-3 minutes), automatically lowers the dewar flask, and gently heats the sample cell back to room temperature using a built-in hot-air blower. As a result, the desorbed gas signal is displayed on a digital meter and the surface area is directly presented on a front panel display. The entire measurement (adsorption and desorption) cycle typically requires less than six minutes. The technique uses a high sensitivity, thermal conductivity detector to measure the change in concentration of an adsorbate/inert carrier gas mixture as adsorption and desorption proceed. When integrated by the on-board electronics and compared to calibration, the detector provides the volume of gas adsorbed or desorbed. A builtin microprocessor ensures linearity and automatically computes the sample's BET surface area in m²/g.

In one embodiment according to the invention, glass frit particles have a specific surface area of at least about 0.1 m²/g, preferably at least about 0.2 m²/g. At the same time, the coated metallic particles have a specific surface area, as set forth herein, of not more than about 10 m²/g, preferably not more than about 7 m²/g.

According to another embodiment, the glass frit particles may include a surface coating. Any such coating known in the art and which is considered to be suitable in the context of the invention can be employed on the glass frit particles. Preferred coatings according to the invention are those coatings which promote improved adhesion of the electroconductive paste. If such a coating is present, it is preferred that the coating correspond to no more than about 10 wt%, preferably no more than about 8 wt%, most preferably no more than about 5 wt%, in each case based on the total weight of the glass frit particles.

### Organic Vehicle

Preferred organic vehicles in the context of the invention are solutions, emulsions or dispersions based on one or more solvents, preferably an organic solvent, which ensure that the constituents of the electroconductive paste are present in a dissolved, emulsified or dispersed form. Preferred organic vehicles are those which provide optimal stability of constituents within the electroconductive paste and endow the electroconductive paste with a viscosity allowing effective printability.

In one embodiment, the organic vehicle comprises an organic solvent and one or more of a binder (e.g., a polymer), a surfactant or a thixotropic agent, or any combination thereof. For example, in one embodiment, the organic vehicle comprises one or more binders in an organic solvent.

Preferred binders in the context of the invention are those which contribute to the formation of an electroconductive paste with favorable stability, printability, viscosity and sintering properties. Binders are well known in the art. Preferred binders according to the invention (which often fall within the category termed "resins") are polymeric binders, monomeric binders, and binders which are a combination of polymers and monomers. Polymeric binders can also be copolymers wherein at least two different monomeric units are contained in a single molecule. Preferred polymeric binders are those which carry functional groups in the polymer main chain, those which carry functional groups off of the main chain and those which carry functional groups both within the main chain and off of the main chain. Preferred polymers carrying functional groups in the main chain are for example polyesters, substituted polyesters, polycarbonates, substituted polycarbonates, polymers which carry cyclic groups in the main chain, poly-sugars, substituted poly-sugars, polyurethanes, substituted polyurethanes, polyamides, substituted polyamides, phenolic resins, substituted phenolic resins, copolymers of the monomers of one or more of the preceding polymers, optionally with other comonomers, or a combination of at least two thereof. According to one embodiment, the binder may be polyvinyl butyral or polyethylene. Preferred polymers which carry cyclic groups in the main chain are for example polyvinylbutylate (PVB) and its derivatives and poly-terpineol and its derivatives or mixtures thereof. Preferred poly-sugars are for example cellulose and alkyl derivatives thereof, preferably methyl cellulose, ethyl cellulose, hydroxyethyl cellulose, propyl cellulose, hydroxypropyl cellulose, butyl cellulose and their derivatives and mixtures of at least two thereof. Preferred polymers which carry functional groups off of the main polymer chain are those which carry amide groups, those which carry acid and/or ester groups, often called acrylic resins, or polymers which carry a combination of aforementioned functional groups, or a combination thereof. Preferred polymers which carry amide off of the main chain are for example polyvinyl pyrrolidone (PVP) and its derivatives. Preferred polymers which carry acid and/or ester groups off of the main chain are for example polyacrylic acid and its derivatives, polymethacrylate (PMA) and its derivatives or polymethylmethacrylate (PMMA) and its derivatives, or a mixture thereof. Preferred monomeric binders according to the invention are ethylene glycol based monomers, terpineol resins or rosin derivatives, or a mixture thereof. Preferred monomeric binders based on ethylene glycol are those with ether groups, ester groups or those with an ether group and an ester group, preferred ether groups being methyl, ethyl, propyl, butyl, pentyl hexyl and higher alkyl ethers, the preferred ester group being acetate and its alkyl derivatives, preferably ethylene glycol monobutylether monoacetate or a mixture thereof. Alkyl cellulose, preferably ethyl cellulose, its derivatives and mixtures thereof with other binders from the preceding lists of binders or otherwise are the most preferred binders in the context of the invention. The binder may be present in an amount of at least about 0.1 wt%, and preferably at least 0.5 wt%. At the same time, binder may be present in an amount of not more than about 10 wt%, preferably not more than about 8 wt%, and more preferably not more than about 7 wt%, based upon 100% total weight of the organic vehicle.

Preferred solvents according to the invention are constituents of the electroconductive paste which are removed from the paste to a significant extent during firing, preferably those which are present after firing with an absolute weight reduced by at least about 80% compared to before firing, preferably reduced by at least about 95% compared to before firing. Preferred solvents according to the invention are those which allow an electroconductive paste to be formed which has favorable viscosity, printability, stability and sintering characteristics. All solvents which are known in the art, and which are considered to be suitable in the context of this invention, may be employed as the solvent in the organic vehicle. According to the invention, preferred solvents are those which allow the preferred high level of printability of the electroconductive paste as described above to be achieved. Preferred solvents according to the invention are those which exist as a liquid under standard ambient temperature and pressure (SATP) (298.15 K, 25 °C, 77 °F), 100 kPa (14.504 psi, 0.986 atm), preferably those with a boiling point above about 90 °C and a melting point above about -20 °C. Preferred solvents according to the invention are polar or non-polar, protic or aprotic, aromatic or nonaromatic. Preferred solvents according to the invention are mono-alcohols, di-alcohols, polyalcohols, mono-esters, di-esters, poly-esters, mono-ethers, di-ethers, poly-ethers, solvents which comprise at least one or more of these categories of functional group, optionally comprising other categories of functional group, preferably cyclic groups, aromatic groups, unsaturated bonds, alcohol groups with one or more O atoms replaced by heteroatoms, ether groups with one or more O atoms replaced by heteroatoms, esters groups with one or more O atoms replaced by heteroatoms, and mixtures of two or more of the aforementioned solvents. Preferred esters in this context are di-alkyl esters of adipic acid, preferred alkyl constituents being methyl, ethyl, propyl, butyl, pentyl, hexyl and higher alkyl groups or combinations of two different such alkyl groups, preferably dimethyladipate, and mixtures of two or more adipate esters. Preferred ethers in this context are diethers, preferably dialkyl ethers of ethylene glycol, preferred alkyl constituents being methyl, ethyl, propyl, butyl, pentyl, hexyl and higher alkyl groups or combinations of two different such alkyl groups, and mixtures of two diethers. Preferred alcohols in this context are primary, secondary and tertiary alcohols, preferably tertiary alcohols, terpineol and its derivatives being preferred, or a mixture of two or more alcohols. Preferred solvents which combine more than one different functional groups are 2,2,4-trimethyl-1,3-pentanediol monoisobutyrate, often called texanol, and its derivatives, 2-(2-ethoxyethoxy)ethanol, often known as carbitol, its alkyl derivatives, preferably methyl, ethyl, propyl, butyl, pentyl, and hexyl carbitol, preferably hexyl carbitol or butyl carbitol, and acetate derivatives thereof, preferably butyl carbitol acetate, or mixtures of at least two of the aforementioned.

The organic vehicle may also comprise one or more surfactants and/or additives. Preferred surfactants in the context of the invention are those which contribute to the formation of an electroconductive paste with favorable stability, printability, viscosity and sintering properties. Surfactants are well known to the person skilled in the art. All surfactants which are known in the art, and which are considered to be suitable in the context of this invention, may be employed as the surfactant in the organic vehicle. Preferred surfactants in the context of the invention are those based on linear chains, branched chains, aromatic chains, fluorinated chains, siloxane chains, polyether chains and combinations thereof. Preferred surfactants are single chained, double chained or poly chained. Preferred surfactants according to the invention may have non-ionic, anionic, cationic, amphiphilic, or zwitterionic heads- Preferred surfactants are polymeric and monomeric or a mixture thereof. Preferred surfactants according to the invention can have pigment affinic groups, preferably hydroxyfunctional carboxylic acid esters with pigment affinic groups (e.g., DISPERBYK^{®}-108, manufactured by BYK USA, Inc.), acrylate copolymers with pigment affinic groups (e.g., DISPERBYK^{®}-116, manufactured by BYK USA, Inc.), modified polyethers with pigment affinic groups (e.g., TEGO^{®} DISPERS 655, manufactured by Evonik Tego Chemie GmbH), other surfactants with groups of high pigment affinity (e.g., TEGO^{®} DISPERS 662 C, manufactured by Evonik Tego Chemie GmbH). Other preferred polymers according to the invention not in the above list are polyethylene oxide, polyethylene glycol and its derivatives, and alkyl carboxylic acids and their derivatives or salts, or mixtures thereof. The preferred polyethylene glycol derivative according to the invention is poly(ethyleneglycol)acetic acid. Preferred alkyl carboxylic acids are those with fully saturated and those with singly or poly unsaturated alkyl chains or mixtures thereof. Preferred carboxylic acids with saturated alkyl chains are those with alkyl chains lengths in a range from about 8 to about 20 carbon atoms, preferably C₉H₁₉COOH (capric acid), C₁₁H₂₃COOH (Lauric acid), C₁₃H₂₇COOH (myristic acid) C₁₅H₃₁COOH (palmitic acid), C₁₇H₃₅COOH (stearic acid), or salts or mixtures thereof. Preferred carboxylic acids with unsaturated alkyl chains are C₁₈H₃₄O₂ (oleic acid) and C₁₈H₃₂O₂ (linoleic acid). The preferred monomeric surfactant according to the invention is benzotriazole and its derivatives. The surfactant, when present, may be in the organic vehicle in an amount of at least about 0.01 wt%. At the same time, the surfactant, when present, may be in the organic vehicle in an amount of not more than about 10 wt%, preferably not more than about 8 wt%, and more preferably not more than about 6 wt%, based upon 100% total weight of the organic vehicle.

Preferred additives in the organic vehicle are those additives which are distinct from the aforementioned vehicle components and which contribute to favorable properties of the electroconductive paste, such as advantageous viscosity and adhesion to the underlying substrate. Additives known in the art, and which are considered to be suitable in the context of the invention, may be employed as an additive in the organic vehicle. Preferred additives according to the invention are thixotropic agents, viscosity regulators, stabilizing agents, inorganic additives, thickeners, emulsifiers, dispersants or pH regulators. Preferred thixotropic agents in this context are carboxylic acid derivatives, preferably fatty acid derivatives or combinations thereof Preferred fatty acid derivatives are C₉H₁₉COOH (capric acid), C₁₁H₂₃COOH (Lauric acid), C₁₃H₂₇COOH (myristic acid) C₁₅H₃₁COOH (palmitic acid), C₁₇H₃₅COOH (stearic acid) C₁₈H₃₄O₂ (oleic acid), C₁₈H₃₂O₂ (linoleic acid) or combinations thereof. A preferred combination comprising fatty acids in this context is castor oil.

In one embodiment, the organic vehicle is present in the electroconductive paste in an amount of at least about 1 wt%, preferably at least about 5 wt% organic vehicle. At the same time, the paste comprises not more than about 20 wt%, preferably not more than about 15 wt% organic vehicle, based upon 100% total weight of the paste.

### Additives

Preferred additives in the context of the invention are components added to the electroconductive paste, in addition to the other components explicitly mentioned, which contribute to increased performance of the electroconductive paste, of the electrodes produced thereof, or of the resulting solar cell. All additives known in the art, and which are considered suitable in the context of the invention, may be employed as additives in the electroconductive paste. In addition to additives present in the glass frit and in the vehicle, additives can also be present in the electroconductive paste. Preferred additives according to the invention include thixotropic agents, viscosity regulators, emulsifiers, stabilizing agents or pH regulators, inorganic additives, thickeners and dispersants, or a combination of at least two thereof. Preferred inorganic organometallic additives in this context according to the invention are Mg, Ni, Te, W, Zn, Mg, Gd, Ce, Zr, Ti, Mn, Sn, Ru, Co, Fe, Cu and Cr or a combination of at least two thereof, preferably Zn, Sb, Mn, Ni, W, Te and Ru, or a combination of at least two thereof, oxides thereof, compounds which can generate those metal oxides on firing, or a mixture of at least two of the aforementioned metals, a mixture of at least two of the aforementioned oxides, a mixture of at least two of the aforementioned compounds which can generate those metal oxides on firing, or mixtures of two or more of any of the above mentioned.

According to one embodiment, an additive or additives are present in the paste composition in an amount of at least about 0.1 wt%. At the same time, the additive or additives are present in the paste composition in an amount of not more than about 10 wt%, preferably not more than about 5 wt%, and more preferably not more than about 2 wt%, based upon 100% total weight of the paste.

### Forming the Electroconductive Composition

To form an electroconductive composition, the coated conductive metallic particles are combined with an organic vehicle using any method known in the art for preparing an electroconductive composition. In another embodiment, the coated conductive metallic particles are combined with an organic vehicle and a glass frit using any method known in the art for preparing an electroconductive composition.

The method of preparation is not critical, as long as it results in a homogenously dispersed paste. The components can be mixed, such as with a mixer, then passed through a three roll mill, for example, to make a dispersed uniform paste.

The coated metallic particles may be extracted from the electroconductive paste composition for analysis using any methods known in the art.

The electroconductive composition may be applied to at least one surface of a substrate. In one embodiment, once applied to a substrate, the electroconductive composition may be subjected to one or more thermal treatment steps (e.g., drying, curing, firing, and any combination thereof), one or more light curing steps, or both. In one embodiment, the thermal treatment steps may be conducted at a temperature of from about 20°C to about 1,000°C. Such steps are useful in forming an electric device such as those described herein.

### Solar Cells

The invention also relates to a solar cell. In one embodiment, the solar cell comprises a semiconductor substrate (e.g., a silicon wafer) and an electroconductive composition according to any of the embodiments described herein.

In another aspect, the invention relates to a solar cell prepared by a process which includes applying an electroconductive composition according to any of the embodiments described herein to a semiconductor substrate (e.g., a silicon wafer) and firing the semiconductor substrate.

### Silicon Wafer

Preferred wafers according to the invention have regions, among other regions of the solar cell, capable of absorbing light with high efficiency to yield electron-hole pairs and separating holes and electrons across a boundary with high efficiency, preferably across a p-n junction boundary. Preferred wafers according to the invention are those comprising a single body made up of a front doped layer and a back doped layer.

Preferably, the wafer comprises appropriately doped tetravalent elements, binary compounds, tertiary compounds or alloys. Preferred tetravalent elements in this context include, but are not limited to, silicon, germanium, or tin, preferably silicon. Preferred binary compounds include, but are not limited to, combinations of two or more tetravalent elements, binary compounds of a group III element with a group V element, binary compounds of a group II element with a group VI element or binary compounds of a group IV element with a group VI element. Preferred combinations of tetravalent elements include, but are not limited to, combinations of two or more elements selected from silicon, germanium, tin or carbon, preferably SiC. The preferred binary compounds of a group III element with a group V element is GaAs. According to a preferred embodiment of the invention, the wafer is silicon. The foregoing description, in which silicon is explicitly mentioned, also applies to other wafer compositions described herein.

The p-n junction boundary is located where the front doped layer and back doped layer of the wafer meet. In an n-type solar cell, the back doped layer is doped with an electron donating n-type dopant and the front doped layer is doped with an electron accepting or hole donating p-type dopant. In a p-type solar cell, the back doped layer is doped with p-type dopant and the front doped layer is doped with n-type dopant. According to a preferred embodiment of the invention, a wafer with a p-n junction boundary is prepared by first providing a doped silicon substrate and then applying a doped layer of the opposite type to one face of that substrate.

The doped silicon substrate can be prepared by any method known in the art and considered suitable for the invention. Preferred sources of silicon substrates according to the invention include, but are not limited to, mono-crystalline silicon, multi-crystalline silicon, amorphous silicon and upgraded metallurgical silicon, most preferably mono-crystalline silicon or multi-crystalline silicon. Doping to form the doped silicon substrate can be carried out simultaneously by adding the dopant during the preparation of the silicon substrate, or it can be carried out in a subsequent step. Doping subsequent to the preparation of the silicon substrate can be carried out by gas diffusion epitaxy, for example. Doped silicon substrates are also readily commercially available. According to one embodiment, the initial doping of the silicon substrate may be carried out simultaneously to its formation by adding dopant to the silicon mix. According to another embodiment, the application of the front doped layer and the highly doped back layer, if present, may be carried out by gas-phase epitaxy. This gas phase epitaxy is preferably carried out at a temperature of at least about 500 °C, preferably at least about 600°C, and most preferably at least about 650°C. At the same time, the temperature is preferably no more than about 900°C, preferably no more than about 800°C, and most preferably no more than about 750°C. The gas phase epitaxy is preferably carried out at a pressure of at least about 2 kPa, preferably at least about 10 kPa, and most preferably at least about 40 kPa. At the same, the pressure is preferably no more than about 100 kPa, preferably no more than about 80 kPa, and most preferably no more than about 70 kPa.

It is known in the art that silicon substrates can exhibit a number of shapes, surface textures and sizes. The shape of the substrate may include cuboid, disc, wafer and irregular polyhedron, to name a few. According to a preferred embodiment of the invention, the wafer is a cuboid with two dimensions which are similar, preferably equal, and a third dimension which is significantly smaller than the other two dimensions. The third dimension may be at least 100 times smaller than the first two dimensions. Further, silicon substrates with rough surfaces are preferred. One way to assess the roughness of the substrate is to evaluate the surface roughness parameter for a sub-surface of the substrate, which is small in comparison to the total surface area of the substrate, preferably less than about one hundredth of the total surface area, and which is essentially planar. The value of the surface roughness parameter is given by the ratio of the area of the sub-surface to the area of a theoretical surface formed by projecting that sub-surface onto the flat plane best fitted to the sub-surface by minimizing mean square displacement. A higher value of the surface roughness parameter indicates a rougher, more irregular surface and a lower value of the surface roughness parameter indicates a smoother, more even surface. According to the invention, the surface roughness of the silicon substrate is preferably modified so as to produce an optimum balance between a number of factors including, but not limited to, light absorption and adhesion to the surface.

The two larger dimensions of the silicon substrate can be varied to suit the application required of the resultant solar cell. It is preferred according to the invention for the thickness of the silicon wafer to be below about 0.5 mm, more preferably below about 0.3 mm, and most preferably below about 0.2 mm. Some wafers have a minimum thickness of 0.01 mm or more.

It is preferred that the front doped layer be thin in comparison to the back doped layer. It is also preferred that the front doped layer have a thickness of at least about 0.1 µm, and preferably no more than about 10 µm, preferably no more than about 5 µm, and most preferably no more than about 2 µm.

A highly doped layer can be applied to the back face of the silicon substrate between the back doped layer and any further layers. Such a highly doped layer is of the same doping type as the back doped layer and such a layer is commonly denoted with a + (n+-type layers are applied to n-type back doped layers and p+-type layers are applied to p-type back doped layers). This highly doped back layer serves to assist metallization and improve electroconductive properties. It is preferred according to the invention for the highly doped back layer, if present, to have a thickness of at least 1 µm, and preferably no more than about 100 µm, preferably no more than about 50 µm and most preferably no more than about 15 µm.

### Dopants

Preferred dopants are those which, when added to the silicon wafer, form a p-n junction boundary by introducing electrons or holes into the band structure. It is preferred that the identity and concentration of these dopants is specifically selected so as to tune the band structure profile of the p-n junction and set the light absorption and conductivity profiles as required. Preferred p-type dopants include, but are not limited to, those which add holes to the silicon wafer band structure. All dopants known in the art and which are considered suitable in the context of the invention can be employed as p-type dopants. Preferred p-type dopants include, but are not limited to, trivalent elements, particularly those of group 13 of the periodic table. Preferred group 13 elements of the periodic table in this context include, but are not limited to, boron, aluminum, gallium, indium, thallium, or a combination of at least two thereof, wherein boron is particularly preferred.

Preferred n-type dopants are those which add electrons to the silicon wafer band structure. Preferred n-type dopants are elements of group 15 of the periodic table. Preferred group 15 elements of the periodic table in this context include, but are not limited to, nitrogen, phosphorus, arsenic, antimony, bismuth or a combination of at least two thereof, wherein phosphorus is particularly preferred.

As described above, the various doping levels of the p-n junction can be varied so as to tune the desired properties of the resulting solar cell. Doping levels are measured using secondary ion mass spectroscopy.

According to certain embodiments, the semiconductor substrate (i.e., silicon wafer) exhibits a sheet resistance above about 60 Ω/□, such as above about 65 Ω/□, 70 Ω/□, 90 Ω/□, or 100 Ω/□. For measuring the sheet resistance of a doped silicon wafer surface, the device "GP4-Test Pro" equipped with software package "GP-4 Test 1.6.6 Pro" (available from GP Solar GmbH) is used. For the measurement, the four point measuring principle is applied. The two outer probes apply a constant current and two inner probes measure the voltage. The sheet resistance is deduced using the Ohmic law in Ω/□. To determine the average sheet resistance, the measurement is performed on 25 equally distributed spots of the wafer. In an air conditioned room with a temperature of 22 ± 1 °C, all equipment and materials are equilibrated before the measurement. To perform the measurement, the "GP-Test.Pro" is equipped with a 4-point measuring head (Part Number 04.01.0018) with sharp tips in order to penetrate the anti-reflection and/or passivation layers. A current of 10 mA is applied. The measuring head is brought into contact with the non metalized wafer material and the measurement is started. After measuring 25 equally distributed spots on the wafer, the average sheet resistance is calculated in Ω/□.

### Solar Cell Structure

A contribution to achieving at least one of the above described objects is made by a solar cell obtainable from a process according to the invention. Preferred solar cells according to the invention are those which have a high efficiency, in terms of proportion of total energy of incident light converted into electrical energy output, and those which are light and durable. At a minimum, a solar cell includes: (i) front electrodes, (ii) a front doped layer, (iii) a p-n junction boundary, (iv) a back doped layer, and (v) soldering pads. The solar cell may also include additional layers for chemical/mechanical protection.

### Antireflective Layer

According to the invention, an antireflective layer may be applied as the outer layer before the electrode is applied to the front face of the solar cell. All antireflective layers known in the art and which are considered to be suitable in the context of the invention can be employed. Preferred antireflective layers are those which decrease the proportion of incident light reflected by the front face and increase the proportion of incident light crossing the front face to be absorbed by the wafer. Antireflective layers which give rise to a favorable absorption/reflection ratio, are susceptible to etching by the electroconductive composition, are otherwise resistant to the temperatures required for firing of the electroconductive composition, and do not contribute to increased recombination of electrons and holes in the vicinity of the electrode interface, are preferred. Preferred antireflective layers include, but are not limited to, SiNₓ, SiO₂, Al₂O₃, TiO₂ or mixtures of at least two thereof and/or combinations of at least two layers thereof. According to a preferred embodiment, the antireflective layer is SiNₓ, in particular where a silicon wafer is employed.

The thickness of antireflective layers is suited to the wavelength of the appropriate light. According to a preferred embodiment of the invention, the antireflective layers have a thickness of at least 20 nm, preferably at least 40 nm, and most preferably at least 60 nm. At the same time, the thickness is preferably no more than about 300 nm, more preferably no more than about 200 nm, and most preferably no more than about 90 nm.

### Passivation Layers

One or more passivation layers may be applied to the front and/or back side of the silicon wafer as an outer layer. The passivation layer(s) may be applied before the front electrode is formed, or before the antireflective layer is applied (if one is present). Preferred passivation layers are those which reduce the rate of electron/hole recombination in the vicinity of the electrode interface. Any passivation layer which is known in the art and which is considered to be suitable in the context of the invention can be employed. Preferred passivation layers according to the invention include, but are not limited to, silicon nitride, silicon dioxide and titanium dioxide. According to a more preferred embodiment, silicon nitride is used. It is preferred for the passivation layer to have a thickness of at least 0.1 nm, preferably at least 10 nm, and most preferably at least 30 nm. As the same time, the thickness is preferably no more than about 2 µm, preferably no more than about 1 µm, and most preferably no more than about 200 nm.

### Additional Protective Layers

In addition to the layers described above, further layers can be added for mechanical and chemical protection. The cell can be encapsulated to provide chemical protection. According to a preferred embodiment, transparent polymers, often referred to as transparent thermoplastic resins, are used as the encapsulation material, if such an encapsulation is present. Preferred transparent polymers in this context are silicon rubber and polyethylene vinyl acetate (PVA). A transparent glass sheet may also be added to the front of the solar cell to provide mechanical protection to the front face of the cell. A back protecting material may be added to the back face of the solar cell to provide mechanical protection. Preferred back protecting materials are those having good mechanical properties and weather resistance. The preferred back protection material according to the invention is polyethylene terephthalate with a layer of polyvinyl fluoride. It is preferred for the back protecting material to be present underneath the encapsulation layer (in the event that both a back protection layer and encapsulation are present).

A frame material can be added to the outside of the solar cell to give mechanical support. Frame materials are well known in the art and any frame material considered suitable in the context of the invention may be employed. The preferred frame material according to the invention is aluminum.

### Method of Preparing a Solar Cell

A solar cell may be prepared by applying the electroconductive composition of the invention to an antireflection coating, such as silicon nitride, silicon oxide, titanium oxide or aluminum oxide, on the front side of a semiconductor substrate, such as a silicon wafer. A backside electroconductive composition is then applied to the backside of the solar cell to form soldering pads. An aluminum paste is then applied to the backside of the substrate, overlapping the edges of the soldering pads formed from the backside electroconductive composition, to form the BSF.

The electroconductive compositions may be applied in any manner known in the art and considered suitable in the context of the invention. Examples include, but are not limited to, impregnation, dipping, pouring, dripping on, injection, spraying, knife coating, curtain coating, brushing, screen printing, printing, or a combination of at least two thereof. Preferred printing techniques are ink-jet printing, screen printing, tampon printing, offset printing, relief printing or stencil printing or a combination of at least two thereof. It is preferred according to the invention that the electroconductive composition is applied by printing, preferably by screen printing. Specifically, the screens preferably have mesh opening with a diameter of at least about 10 µm, preferably at least about 20 µm. At the same time, the screens preferably have a mesh opening of no more than about 80 µm, preferably no more than about 60 µm, and most preferably no more than about 50 µm.

The substrate is then fired according to an appropriate profile. Firing is necessary to sinter the printed electroconductive composition so as to form solid electrodes. Firing is well known in the art and can be effected in any manner considered suitable in the context of the invention. It is preferred that firing be carried out above the T_{g} of the glass frit materials.

According to the invention, the maximum temperature set for firing is below about 900°C, preferably below about 860°C. Firing temperatures as low as about 770°C have been employed for obtaining solar cells. Firing temperatures should also allow for effective sintering of the metallic particles to be achieved. The firing temperature profile is typically set so as to enable the burnout of organic materials from the electroconductive composition. The firing step is typically carried out in air or in an oxygen-containing atmosphere in a belt furnace. It is preferred for firing to be carried out in a fast firing process with a total firing time of at least 30 seconds, and preferably at least 40 seconds. At the same time, the firing time is preferably no more than about 3 minutes, more preferably no more than about 2 minutes, and most preferably no more than about 1 minute. The time above 600°C is most preferably in a range from about 3 to 7 seconds. The substrate may reach a peak temperature in the range of about 700 to 900°C for a period of about 1 to 5 seconds. The firing may also be conducted at high transport rates, for example, about 100-700 cm/min, with resulting hold-up times of about 0.5 to 3 minutes. Multiple temperature zones, for example 3-12 zones, can be used to control the desired thermal profile.

Firing of electroconductive compositions on the front and back faces can be carried out simultaneously or sequentially. Simultaneous firing is appropriate if the electroconductive compositions applied to both faces have similar, preferably identical, optimum firing conditions. Where appropriate, it is preferred for firing to be carried out simultaneously. Where firing is carried out sequentially, it is preferable for the back electroconductive composition to be applied and fired first, followed by application and firing of the electroconductive composition to the front face of the substrate.

### Measuring properties of Electroconductive Composition

The sample solar cell is characterized using a commercial IV-tester "cetisPV-CTL1" from Halm Elektronik GmbH. All parts of the measurement equipment as well as the solar cell to be tested were maintained at 25°C during electrical measurement. This temperature should be measured simultaneously on the cell surface during the actual measurement by a temperature probe. The Xe Arc lamp simulates the sunlight with a known AM1.5 intensity of 1000 W/m² on the cell surface. To bring the simulator to this intensity, the lamp is flashed several times within a short period of time until it reaches a stable level monitored by the "PVCTControl 4.313.0" software of the IV-tester. The Halm IV tester uses a multi-point contact method to measure current (I) and voltage (V) to determine the solar cell's IV-curve. To do so, the solar cell is placed between the multi-point contact probes in such a way that the probe fingers are in contact with the bus bars (i.e., printed lines) of the solar cell. The numbers of contact probe lines are adjusted to the number of bus bars on the cell surface. All electrical values were determined directly from this curve automatically by the implemented software package. As a reference standard, a calibrated solar cell from ISE Freiburg consisting of the same area dimensions, same wafer material, and processed using the same front side layout, was tested and the data was compared to the certificated values. At least five wafers processed in the very same way were measured and the data was interpreted by calculating the average of each value. The software PVCTControl 4.313.0 provides values for efficiency, fill factor, short circuit current, series resistance and open circuit voltage.

### Solar Cell Module

A plurality of solar cells according to the invention can be arranged spatially and electrically connected to form a collective arrangement called a module. Preferred modules according to the invention can have a number of arrangements, preferably a rectangular arrangement known as a solar panel. A large variety of ways to electrically connect solar cells, as well as a large variety of ways to mechanically arrange and fix such cells to form collective arrangements, are well known in the art. Preferred methods according to the invention are those which result in a low mass to power output ratio, low volume to power output ration, and high durability. Aluminum is the preferred material for mechanical fixing of solar cells according to the invention.

In one embodiment, multiple solar cells are connected in series and/or in parallel and the ends of the electrodes of the first cell and the last cell are preferably connected to output wiring. The solar cells are typically encapsulated in a transparent thermal plastic resin, such as silicon rubber or ethylene vinyl acetate. A transparent sheet of glass is placed on the front surface of the encapsulating transparent thermal plastic resin. A back protecting material, for example, a sheet of polyethylene terephthalate coated with a film of polyvinyl fluoride, is placed under the encapsulating thermal plastic resin. These layered materials may be heated in an appropriate vacuum furnace to remove air, and then integrated into one body by heating and pressing. Furthermore, since solar cells are typically left in the open air for a long time, it is desirable to cover the circumference of the solar cell with a frame material consisting of aluminum or the like.

The invention will now be described in conjunction with the following, non-limiting examples.

### Example 1

225 g of silver powder (a mixture of 50% having a d₅₀ of 1.4 micron and 50% having a d₅₀ of 2.8 micron) was suspended in isopropanol (150 g). Separately, a solution was prepared by adding 0.150 g rhodium (III) tris ethylhexanoate to 25 g of isopropanol. The rhodium ethylhexanoate solution was then added to the silver/isopropanol slurry and the resulting slurry was mixed for five minutes. A solution of 0.42 g ammonium hydroxide (28% ammonia containing solution, 6 moles per mole of rhodium) in 10 g isopropanol was then added to hydrolyze the rhodium compound onto the silver surface as rhodium hydroxide (without wishing to be bound by theory, the inventor theorizes that the reaction forms rhodium hydroxide and ammonium ethylhexanoate). The resulting slurry was mixed for a further 15 minutes. A solution of oleic acid (0.45 wt% oleic acid based on silver) in isopropanol was then added and the slurry mixed for 15 minutes. The resulting solid was then air dried to evaporate the isopropanol, then dried in a forced hot air convention oven at 50° C for at least 4 hours to afford the coated silver particles, which were subsequently screened thorough a 100 mesh screen to afford 100 ppm (based on silver weight) rhodium coated particles.

A similar procedure was performed to prepare 50 ppm(based on silver weight) rhodium coated silver particles (0.075 g rhodium (III) tris ethylhexanoate was used) and 200 ppm (based on silver weight) rhodium coated silver particles (0.300 g rhodium (III) tris ethylhexanoate and 0.84 g ammonium hydroxide were used).

Three exemplary paste compositions were then prepared containing the components shown in Table 1. Paste A was a control paste in which the silver particles were not rhodium coated. Pastes B and C contained rhodium-coated silver particles (50 ppm and 100 ppm rhodium coating, respectively).

**TABLE 1- Composition of Exemplary Pastes A, B and C**

| | **PASTE A** | **PASTE B** | **PASTE C** |
|---|---|---|---|
| **Component** | **Amount (in wt% of paste)** | | |
| **Glass** | | | |
| **Silver Particles** | 83.62 | 83.62 | 83.62 |
| **Organic Vehicle*** | 11.99 | 11.99 | 11.99 |
| **Vioxx 2303 glass** | 0.78 | 0.78 | 0.78 |
| **Vioxx 2302 glass** | 2.32 | 2.32 | 2.32 |
| **Lithium phosphate** | 1.29 | 1.29 | 1.29 |

The components of the organic vehicle are shown in Table 2.

**TABLE 2**

| **Component** | **Supplier** | **Amount (wt. %)** |
|---|---|---|
| Texanol | Brenntag | 46.10 |
| Staybelite Ester 3 | Ashland Chemical | 14.88 |
| N22 Ethyl Celluose | Aqualon | 0.83 |
| N04 Ethyl Celluose | Aqualon | 4.95 |
| Terpineol | Brenntag | 22.71 |
| Thixatrol Max | Elementis | 10.53 |

To form each paste composition, the components were placed in a plastic vial and premixed for five minutes in a High Energy Shaker-Mill model 8000M MIXER/MILL from SPEX® SamplePrep®, USA. This mixture was then milled in a three-roll mill (e.g., Model No. 80E/0393 from EXAKT Advanced Technologies GmbH, Germany). The gap between the rollers was maintained at 5 µm to 25 µm and the speed was varied from 20 rpm to 300 rpm. Each sample was passed at least 4 times through the mill in order to provide a homogeneous paste.

Each paste was screen printed onto the front side of a lightly-doped p-type Motech Virgo multicrystalline silicon wafer with a sheet resistance of 85 Ω/sq, at a speed of 150 mm/s, using a 325 (mesh) * 0.9 (mil, wire diameter) * 0.6 (mil, emulsion thickness) * 40 µm (finger line opening) calendar screen. An aluminum back side paste was also applied to the back side of the silicon wafer. The printed wafer was dried at 150°C and then fired at a profile with the peak temperature at about 750-900°C for a few seconds in a linear multi-zone infrared furnace.

Each resulting solar cell was then tested according to the parameters set forth herein, and various electrical performance properties were determined, including efficiency, Voc, Fill Factor and front side series resistance (Rs3, Ω). Electrical performance data for Pastes A, B and C is compiled in Table 3.

**TABLE 3 - Electrical Performance of Pastes A, B and C**

| **Performance** | **Paste A** | **Paste B** | **Paste C** |
|---|---|---|---|
| **Efficiency (normalized)** | 100.0 | 112.9 | 116.8 |
| **Voc (normalized)** | 100.0 | 100.4 | 100.3 |
| **Fill Factor (normalized)** | 100.0 | 112.7 | 116.7 |
| **Rs3(Ω)** | 100.0 | 51.8 | 36.7 |

### Example 2

For the coated particles described in Table 4, inorganic coatings were applied to a silver powder. The powder has a tap density of 5.1 g/cc, a specific surface area by the BET method of 0.32 m²/g, a median particle size (D50) of 1.38 um, and an ignition loss of 0.32% from ammonium oleate coating. The inorganic coatings were applied by using the following procedure:

(1) In a 50 ml beaker, the coating agent was premixed in 30 milliliters isopropyl alcohol. (2) In a 400 ml beaker, 200 g of the silver powder was added to 150 ml isopropyl alcohol and stirred to form a uniform dispersion. (3) With continued stirring, the coating agent solution was added to the the silver dispersion (2) and mixed for five minutes. (4) In a 50 ml beaker, 0.2 g deionized water was premixed in 10 ml isopropyl alcohol. With continued stirring, the water / isopropyl alcohol mixture (4) was added to the silver dispersion mixture (3) and mixed for 15 minutes. The resulting coated particles were air dried, then, when visually dry, were placed in a 50°C oven for at least four hours.

**TABLE 4**

| Coating (ppm) | Inorganic Precursor (Amount) | Solvent (Amount) | NH₄OH (g) | Organic Coating |
|---|---|---|---|---|
| TeO₂ (443) | Te(OEt)₄/85% ETOH Hydrolyzed with 0.2g H₂O/10g isopropyl alcohol | Isopropyl alcohol (30 ml) | 0 | Ammonium oleate on parent powder |
| | (0.21 g) | | | |
| TeO₂ (260) | Te(OEt)₄/ 85% EtOH Hydrolyzed with 0.2g H₂O/10g isopropyl alcohol | isopropyl alcohol (30 ml) | 0 | Ammonium oleate on parent powder |
| | (0.14 g) | | | |
| TeO₂ | Te(OEt)₄/ 85% EtOH | isopropyl | 0 | Ammonium oleate |
| (120) | Hydrolyzed with 0.2g H₂O/10g isopropyl alcohol | alcohol (30 ml) | | on parent powder |
| | (0.07 g) | | | |
| ZrO₂ (1054) | Zr(OⁿPr)₄/70% ⁿPrOH Hydrolyzed with 0.36g H₂O/10g isopropyl alcohol | isopropyl alcohol (30 g) | 0 | Ammonium oleate on parent powder |
| | (1.08 g) | | | |
| ZrO₂ (264) | Zr(OⁿPr)₄ / 70% ⁿPrOH Hydrolyzed with 0.36g H₂O/10g isopropyl alcohol | isopropyl alcohol (10g) | 0 | Ammonium oleate on parent powder |
| | (0.27 g) | | | |
| ZrO₂ (176) | Zr(OⁿPr)₄/70% ⁿPrOH Hydrolyzed with 0.36g H₂O/10g isopropyl alcohol | isopropyl alcohol (10 g) | 0 | Ammonium oleate on parent powder |
| | (0.18 g) | | | |
| ZrO₂ (88) | Zr(OⁿPr)₄/70% ⁿPrOH Hydrolyzed with 0.36g H₂O/10g isopropyl alcohol | isopropyl alcohol (10 g) | 0 | Ammonium oleate on parent powder |
| | (0.09 g) | | | |

### Example 3

For the coated particles described in Table 5, inorganic coatings were applied to a silver powder which was freshly prepared in the laboratory in 240 g batches. The particle size of the silver powder ranged from 1.80 - 2.67 µm. After the silver powder was prepared, it was washed clean of byproducts with deionized water, then transferred to a 1000 milliliter beaker and rinsed once with isopropyl alcohol. After the alcohol rinse, the powder was allowed settled then the excess alcohol was decanted off. Inorganic coatings were then applied to the wet silver slurry by using the following procedure.

(1) In a 50 ml beaker, the inorganic coating agent was premixed in 25 g alcohol. (2) In a 50 ml beaker, the organic coating agent was premixed in 25 g isopropyl alcohol. (3) In a 50 ml beaker, ammonium hydroxide (28% ammonia) was premixed in 10 grams isopropyl alcohol. (4) To the wet silver slurry described above, 200 g isopropyl alcohol was added and the resulting mixture stirred to form a uniform dispersion. (5) With continued stirring, the coating agent solution (1) was added to the silver dispersion (4) and mixed for five minutes. (6) With continued stirring, the ammonium hydroxide / alcohol solution (3) was added to the silver dispersion (5) and mixed for 15 minutes. (7) With continued stirring, the organic coating agent solution (2) was added to the silver dispersion (6) and mixed for 15 minutes. The resulting coated particles were air dried, then, when visually dry, were placed in a 50°C oven for at least four hours.

**TABLE 5**

| Coating (ppm) | Inorganic Precursor (Amount) | Solvent (Amount) | NH₄OH (g) | Organic Coating |
|---|---|---|---|---|
| TeO₂ (472) | Te(OEt)₄/ 85% EtOH Hydrolyzed with 0.2g H₂O/10g isopropyl alcohol | isopropyl alcohol (25 g) | 1.08 g | Oleic acid (0.30%) |
| | (0.341 g) | | | |
| TeO₂ (188) | Te(OEt)₄/8 5% EtOH Hydrolyzed with 0.2g H₂O/10g isopropyl alcohol | isopropyl alcohol(25 g) | 0.62 g | Oleic acid (0.30%) |
| | (0.114g) | | | |
| ZnO | Zinc Acetate | MeOH (25 g) | 1.08 g | Oleic acid (0.30%) |
| (260) | (0.207 g) | | | |
| ZnO | Zinc Acetate | MeOH (25 g) | 0.62 g | Oleic acid (0.30%) |
| (90) | (0.069 g) | | | |
| ZrO₂ | Zr(OⁿPr)₄/70% ⁿPrOH | 1-BuOH (25 g) | 1.08 g | Oleic acid (0.30%) |
| (430) | (0.452 g) | | | |
| ZrO₂ | Zr(OⁿPr)₄/70% "PrOH | 1-BuOH (25 g) | 0.62 g | Oleic acid (0.30%) |
| (143) | (0.147 g) | | | |

### Example 4

For the coated particles described in Table 6, inorganic coatings were applied to silver powder which was freshly prepared in the laboratory in 240 g batches. The particle size of the silver powder ranged from 0.90 -1.11 µm. After the silver powder was synthesized, the powder was washed clean of byproducts with deionized water, then transferred to a 1000 milliliter beaker and rinsed once with isopropyl alcohol. After the alcohol rinse, the powder was allowed to settle then the excess alcohol was decanted off. Inorganic coatings were then applied to the wet silver slurry by using the following procedure.

(1) In a 50 ml beaker, the inorganic coating agent was premixed in 25 g alcohol. (2) In a 50 ml beaker, the organic coating agent was premixed in 25 g isopropyl alcohol. (3) In a 50 ml beaker, the ammonium hydroxide (28% ammonia) was premixed in 25 g isopropyl alcohol. (4) To the wet silver slurry described above, 200 g isopropyl alcohol was added and stirred to form a uniform dispersion. (5) With continued stirring, the coating agent solution (1) was added to the silver dispersion (4) and mixed for five minutes. (6) With continued stirring, the ammonium hydroxide / alcohol solution (3) was added to the silver dispersion (5) and mixed for 15 minutes. (7) With continued stirring, the organic coating agent solution (2) was to the silver dispersion (6) and mixed for 15 minutes. (7) The resulting coated particles were air dried, then, when visually dry, were placed in a 50°C oven for at least four hours.

**TABLE 6**

| Coating (ppm) | Inorganic Precursor (Amount) | Solvent (Amount) | NH₄OH (g) | Organic Coating |
|---|---|---|---|---|
| TeO₂ | Te(OEt)₄/85% EtOH | isopropyl alcohol (25 g) | 3.09 g | Oleic acid (0.45%) |
| (1850) | (1.05 g) | | | |
| TeO₂ | Te(OEt)₄/ 85% EtOH | isopropyl alcohol (25 g) | 6.68 g | Oleic acid (0.45%) |
| (4050) | (2.11 g) | | | |
| ZnO | Zinc Acetate | MeOH (25 g) | 2.02 g | Oleic acid (0.45%) |
| (900) | (0.0.69 g) | | | |
| ZnO | Zinc Acetate | MeOH (25 g) | 4.04 g | Oleic acid (0.45%) |
| (1880) | (1.38 g) | | | |
| PbO | Lead Acetate Trihydrate | MeOH (50 mL) | 1.61 g | Oleic acid (0.45%) |
| (6030) | (2.21 g) | | | |
| ZnO | Zinc Acetate | MeOH (25 g) | 1.80 g | Oleic acid (0.45%) |
| (450) | (0.345 g) | | | |
| TeO2 | Te(OEt)₄/85%EtOH | isopropyl alcohol (25 g) | 1.67 g | Oleic acid (0.45%) |
| (850) | (0.528 g) | | | |

### Example 5

For the coated particles described in Table 7, inorganic coatings were applied to silver powder which was freshly prepared in the laboratory in 200 g batches- The particle size of the silver powder ranged from 0.97 -1.07 µm. After the silver powder was synthesized, the powder was washed clean of byproducts with deionized water, then transferred to a 1000 milliliter beaker and rinsed once with isopropyl alcohol. After the alcohol rinse, the powder was allowed to settle then the excess alcohol was decanted off. Inorganic coatings were then applied to the wet silver slurry by using the following procedure.

(1) In a 400 ml beaker, the silver acetate (inorganic coating agent) was premixed in 200 g methanol. (2) To this, ammonium hydroxide was added to ensure that the silver acetate fully dissolves. (3) The inorganic coating agent was added to the wet silver slurry described above and stirred to form a uniform mixture. The resulting mixture was stirred for 15 minutes. (4) While (3) mixed, in a 50 ml beaker, the organic coating agent was premixed in 25 g isopropyl alcohol. (5) With continued stirring, the organic coating agent solution (4) was added to the silver dispersion (3) and mixed for 15 minutes. The resulting coated particles were air dried, then, when visually dry, were placed in a 50°C oven for at least four hours.

**TABLE 7**

| Coating (ppm) | Inorganic Precursor (Amount) | Solvent (Amount) | NH₄OH (g) | Organic Coating |
|---|---|---|---|---|
| Ag₂O | Silver Acetate | MeOH (200 g) | 0.50 g | Oleic acid (0.45%) |
| (390) | (0.121 g) | | | |
| Ag₂O | Silver Acetate | MeOH (200 g | 0.66 g | Oleic acid (0.45%) |
| (1170) | (0.364 g) | | | |
| Ag₂O | Silver Acetate | MeOH (200 g | 1.00 g | Oleic acid (0.45%) |
| (3510) | (1.09 g) | | | |

### Example 6

For the coated particles described in Table 8, inorganic coatings were applied to silver powder which was freshly prepared in the laboratory in 200 g batches. The particle size of the silver powder ranged from 1.52 - 2.02 µm. After the silver powder was synthesized, the powder was washed clean of byproducts with deionized water, then transferred to a 1000 milliliter beaker and rinsed once with isopropyl alcohol. After the alcohol rinse, the powder was allowed to settle then the excess alcohol was decanted off. Inorganic coatings were then applied to the wet silver slurry by using the following procedure.

In a 400 ml beaker, the silver acetate (inorganic coating agent) was premixed in 200 g methanol. (2) To this, ammonium hydroxide was added to ensure that the silver acetate fully dissolves. (3) The inorganic coating agent was added to the wet silver slurry described above and stirred to form a uniform mixture. The resulting mixture was stirred for 15 minutes. (4) While (3) mixed, in a 50 ml beaker, the organic coating agent was premixed in 25 g isopropyl alcohol. (5) With continued stirring, the organic coating agent solution (4) was added to the silver dispersion (3) and mixed for 15 minutes. The resulting coated particles were air dried, then, when visually dry, were placed in a 50°C oven for at least four hours.

**TABLE 8**

| Coating (ppm) | Inorganic Precursor (Amount) | Solvent (Amount) | NH₄OH (g) | Organic Coating |
|---|---|---|---|---|
| Ag₂O | Silver Acetate | MeOH (200 g | 3.00 g | Oleic acid (0.45%) |
| (7000) | (2.62 g) | | | |
| Ag₂O | Silver Acetate | MeOH (200 g | 1.50 g | Oleic acid (0.45%) |
| (3500) | (1.31 g) | | | |

Exemplary paste compositions containing the coated silver particles described in Tables 4-8 may be prepared by the procedure described in Example 1.

These and other advantages of the invention will be apparent to those skilled in the art from the foregoing specification. Accordingly, it will be recognized by those skilled in the art that changes or modifications may be made to the above described embodiments without departing from the broad inventive concepts of the invention. Specific dimensions of any particular embodiment are described for illustration purposes only. It should therefore be understood that this invention is not limited to the particular embodiments described herein, but is intended to include all changes and modifications that are within the scope and spirit of the invention.

### Further embodiments

I) A conductive metallic particle coated with an organometallic compound, a metal salt, an inorganic oxide, an inorganic hydroxide, or a combination thereof.
II) The conductive metallic particle according to embodiment I, wherein the conductive metallic particle is selected from silver, copper, aluminum, zinc, platinum, palladium, lead, nickel, tungsten, molybdenum, alloys thereof, particles where one metal is coated or mixed with at least another metal, and any combination thereof.
III) The conductive metallic particle according to any one of embodiments I and II, wherein the organometallic compound, metal salt, inorganic oxide, inorganic hydroxide, or combination thereof, is an organometallic compound, a metal salt, an inorganic oxide or an inorganic hydroxide of magnesium, calcium, strontium, barium, rhodium, tellurium, lead, zinc, vanadium, chromium, ytterbium, niobium, molybdenum, manganese, silver, tantalum, tungsten, lanthanum, aluminum, antimony, bismuth, boron, silicon, zirconium, phosphorous, selenium, yttrium, tin, and any combination thereof.
IV) A process for preparing an inorganic coated conductive metallic particle comprising forming an organometallic coating, a metal salt coating, an inorganic oxide coating, an inorganic hydroxide coating, or a combination thereof, on the conductive metallic particle.
V) The process according to embodiment IV, wherein the coating is formed by hydrolyzing an inorganic precursor.
VI) A process for preparing an inorganic coated conductive metallic particle comprising
   (a) obtaining a mixture of at least one conductive metallic particle and at least one inorganic precursor in water, an organic solvent, or a combination thereof;
   (b) hydrolysing the inorganic precursor in the mixture; and
   (c) optionally adding at least one organic compound.
VII) The process according to embodiment VI, wherein step (a) comprises mixing a slurry of at least one conductive metallic particle in water, a first organic solvent, or a combination thereof with a solution of at least one inorganic precursor in water, a second organic solvent, or a combination thereof.
VIII) The process according to any one of embodiments IV-VII, further comprising drying the inorganic coated conductive metallic particle.
IX) The process according to embodiment VIII, wherein the drying is performed at ambient pressure or at less than ambient pressure, at temperatures of about 20° C to about 800° C, over a time period of about 1 second to about 20 days.
X) The process according to embodiment VII, wherein the first organic solvent and the second organic solvent are, independently, selected from one or more hydrocarbons, one or more alcohols, and any combination thereof.
XI) The process according to any one of embodiments IV)-X), wherein the conductive metallic particle is selected from silver, copper, aluminum, zinc, platinum, palladium, lead, nickel, tungsten, molybdenum, alloys thereof, particles where one metal is coated or mixed with at least another metal, and any combination thereof.
XII) The process according to any one of embodiments IV)-XI), wherein the metallic particles have a particle size (d₅₀) of at least about 0.1 µm, preferably at least about 0.3 µm, and not more than about 50 µm, preferably not more than about 10 µm, more preferably not more than about 5 µm, and even more preferably not more than about 3.5 µm.
XIII) The process according to any one of embodiments IV)-XII), wherein the metallic particles have a specific surface area of at least about 0.1 m²/g, preferably at least about 0.2 m²/g, and not more than about 100 m²/g, preferably not more than about 5 m²/g, more preferably not more than about 3 m²/g.
XIV) The process according to any one of embodiments V)-XIII), wherein the inorganic precursor is an organometallic compound, a metal salt, an inorganic oxide, an inorganic hydroxide, or any combination thereof of magnesium, calcium, strontium, barium, rhodium, tellurium, lead, zinc, vanadium, chromium, ytterbium, niobium, molybdenum, manganese, silver, tantalum, tungsten, lanthanum, aluminum, antimony, bismuth, boron, silicon, zirconium, phosphorous, selenium, yttrium, tin, and any combination thereof.
XV) The process according to any one of embodiments V)-XIV), wherein the inorganic precursor is selected from the group consisting of rhodium (III) tris(ethylhexanoate), tellurium ethoxide, lead acetate, bismuth citrate, zinc acetate, zirconium tetra(n-propoxide), silver acetate, silver molybdate, silver tungstate, molybdenum oxide, tungsten oxide, and any combination thereof.
XVI) The process according to any one of embodiments V)-XV), wherein the hydrolysis is performed by adjusting the pH.
XVII) The process according to any one of embodiments V)-XI), wherein the hydrolysis is performed by adding ammonium hydroxide, sodium hydroxide, potassium hydroxide, lithium hydroxide, sulfuric acid, hydrochloric acid, phosphoric acid, acetic acid, and any combination thereof.
XVIII) The process according to any one of embodiments VI)-XVI), wherein the at least one organic compound is selected from the group consisting of amines, fatty acids, copolymers with acidic groups, acrylic acids, phosphoric acid esters, polymer salts having an acid group, carboxylic acid esters having a hydroxyl group, amides, carboxylic acids, phosphonic acids, organic acid anhydrides, acrylic copolymers, phosphates of a copolymer, alkyl ammonium salts of a block copolymer, modified acrylic block copolymers, modified acrylic block copolymers, their salts, and any combination of at least two thereof, and is added to the mixture containing the coated metallic particle.
XIX) A conductive metallic particle prepared by a process according to any one of embodiments IV)-XVIII).
XX) Use of a conductive metallic particle according to any one of embodiments I)-III) and XIX) in a composition.
XXI) The use according to embodiment XX), wherein the composition is selected from a conductive composition, a resistor composition, a dielectric composition, a soldering composition, a decorative composition, a sealing composition, and any combination thereof.
XXII) A composition comprising conductive metallic particles according to any one of embodiments I)-III) and XIX)
XXIII) An electroconductive composition comprising
   (a) a conductive metallic particle according to any one of embodiments I)-III) and XIX);
   (b) an organic vehicle.
XXIV) The electroconductive composition according to embodiment XXIII), further comprising a glass frit.
XXV) The electroconductive composition according to any one of embodiments XXIII) and XXIV), wherein the composition comprises at least about 35 wt%, preferably at least about 50 wt%, more preferably at least about 70 wt% coated conductive metallic particles, and even more preferably at least about 85 wt% coated conductive metallic particles and not more than about 99 wt% coated conductive metallic particles, preferably not more than about 94 wt%, based upon 100% total weight of the paste.
XXVI) A method comprising applying an electroconductive composition according to any one of embodiments XXIII) and XXIV) to at least one surface of a substrate.
XXVII) The method according to embodiment XXVI, further comprising subjecting the electroconductive composition to one or more thermal treatment steps and/or one or more irradiation steps using electromagnetic waves.
XXVIII) The method according to embodiment XXVII), wherein the one or more thermal treatment steps are selected from the group of drying, curing, firing, and any combination thereof, in any order.
XXIX) The method according to any one of embodiments XXVII) and XXVIII), wherein the one or more thermal treatment steps are, independently, conducted at a temperature from about 20° C to about 1000° C.
XXX) An electric device prepared by a method according to any one of embodiments XXVI)-XXIX).
XXXI) The electric device according to embodiment XXX), wherein the device is selected from an electric circuit, a solar cell, an LED, a display, and any combination thereof.
XXXII) A solar cell produced by applying an electroconductive paste composition according to any one of embodiments XXIII) and XXIV) to a silicon wafer and firing the silicon wafer.
XXXIII) A solar cell module comprising electrically interconnected solar cells according to embodiment XXXII).

## Claims

1. A conductive metallic particle coated with an organometallic compound, a metal salt, an inorganic oxide, an inorganic hydroxide, or a combination thereof.

2. The conductive metallic particle according to claim 1, wherein the conductive metallic particle is selected from silver, copper, aluminum, zinc, platinum, palladium, lead, nickel, tungsten, molybdenum, alloys thereof, particles where one metal is coated or mixed with at least another metal, and any combination thereof.

3. The conductive metallic particle according to any one of claims 1 and 2, wherein the organometallic compound, metal salt, inorganic oxide, inorganic hydroxide, or combination thereof, is an organometallic compound, a metal salt, an inorganic oxide or an inorganic hydroxide of magnesium, calcium, strontium, barium, rhodium, tellurium, lead, zinc, vanadium, chromium, ytterbium, niobium, molybdenum, manganese, silver, tantalum, tungsten, lanthanum, aluminum, antimony, bismuth, boron, silicon, zirconium, phosphorous, selenium, yttrium, tin, and any combination thereof.

4. A process for preparing an inorganic coated conductive metallic particle comprising forming an organometallic coating, a metal salt coating, an inorganic oxide coating, an inorganic hydroxide coating, or a combination thereof, on the conductive metallic particle.

5. A process for preparing an inorganic coated conductive metallic particle comprising
(a) obtaining a mixture of at least one conductive metallic particle and at least one inorganic precursor in water, an organic solvent, or a combination thereof;
(b) hydrolysing the inorganic precursor in the mixture; and
(c) optionally adding at least one organic compound.

6. The process according to claim 5, wherein step (a) comprises mixing a slurry of at least one conductive metallic particle in water, a first organic solvent, or a combination thereof with a solution of at least one inorganic precursor in water, a second organic solvent, or a combination thereof.

7. The process according to any one of claims 4-6, further comprising drying the inorganic coated conductive metallic particle.

8. The process according to claim 6, wherein the first organic solvent and the second organic solvent are, independently, selected from one or more hydrocarbons, one or more alcohols, and any combination thereof.

9. The process according to any one of claims 4-8, wherein the conductive metallic particle is selected from silver, copper, aluminum, zinc, platinum, palladium, lead, nickel, tungsten, molybdenum, alloys thereof, particles where one metal is coated or mixed with at least another metal, and any combination thereof.

10. The process according to any one of claims 5-9, wherein the inorganic precursor is an organometallic compound, a metal salt, an inorganic oxide, an inorganic hydroxide, or any combination thereof of magnesium, calcium, strontium, barium, rhodium, tellurium, lead, zinc, vanadium, chromium, ytterbium, niobium, molybdenum, manganese, silver, tantalum, tungsten, lanthanum, aluminum, antimony, bismuth, boron, silicon, zirconium, phosphorous, selenium, yttrium, tin, and any combination thereof.

11. The process according to any one of claims 5-10, wherein the hydrolysis is performed by adjusting the pH.

12. The process according to any one of claims 5-11, wherein the at least one organic compound is selected from the group consisting of amines, fatty acids, copolymers with acidic groups, acrylic acids, phosphoric acid esters, polymer salts having an acid group, carboxylic acid esters having a hydroxyl group, amides, carboxylic acids, phosphonic acids, organic acid anhydrides, acrylic copolymers, phosphates of a copolymer, alkyl ammonium salts of a block copolymer, modified acrylic block copolymers, modified acrylic block copolymers, their salts, and any combination of at least two thereof, and is added to the mixture containing the coated metallic particle.

13. A conductive metallic particle prepared by a process according to any one of claims 4-12.

14. Use of a conductive metallic particle according to any one of claims 1-3 and 13 in a composition.

15. A composition comprising conductive metallic particles according to any one of claims 1-3 and 13.

16. An electroconductive composition comprising
(a) a conductive metallic particle according to any one of claims 1-3 and 13;
(b) an organic vehicle.

17. The electroconductive composition according to claim 16, further comprising a glass frit.

18. A method comprising applying an electroconductive composition according to any one of claims 16 and 17 to at least one surface of a substrate.

19. An electric device prepared by a method according to claim 18.

20. The electric device according to claim 19, wherein the device is selected from an electric circuit, a solar cell, an LED, a display, and any combination thereof.

21. A solar cell produced by applying an electroconductive paste composition according to any one of claims 16 and 17 to a silicon wafer and firing the silicon wafer.

22. A solar cell module comprising electrically interconnected solar cells according to claim 21.
